Europäisches Patentamt

European Patent Office

Office européen des brevets

(19)

(11) **EP 0 560 185 B1**

(12) **EUROPÄISCHE PATENTSCHRIFT**

(45) Veröffentlichungstag und Bekanntmachung des Hinweises auf die Patenterteilung:
**03.09.1997 Patentblatt 1997/36**

(51) Int Cl.6: **H01L 27/082**, H01L 27/06

(21) Anmeldenummer: **93103351.8**

(22) Anmeldetag: **03.03.1993**

(54) **Leistungs-Spannungsbegrenzungsschaltung**

Power voltage limiting circuit

Circuit écrèteur de puissance

(84) Benannte Vertragsstaaten:
**DE ES FR GB IT NL SE**

(30) Priorität: **07.03.1992 DE 4207349**

(43) Veröffentlichungstag der Anmeldung:
**15.09.1993 Patentblatt 1993/37**

(73) Patentinhaber: **TEMIC TELEFUNKEN microelectronic GmbH**
**74072 Heilbronn (DE)**

(72) Erfinder: **Ryman, Lennart**
**W-7100 Heilbronn (DE)**

(74) Vertreter: **Maute, Hans-Jürgen, Dipl.-Ing.**
**TEMIC TELEFUNKEN microelectronic GmbH**
**Postfach 35 35**
**74025 Heilbronn (DE)**

(56) Entgegenhaltungen:
**EP-A- 0 009 957**      **WO-A-82/04509**
**FR-A- 2 363 897**

- **PATENT ABSTRACTS OF JAPAN, vol. 16, no. 67 (E-1168) 19. Februar 1992; & JP-A-32 62 152**
- **PATENT ABSTRACTS OF JAPAN, vol. 4, no. 59 (E-9)(541) 2. Mai 1980; & JP-A-55 29 113**

**Beschreibung**

Die Erfindung betrifft eine Leistungstransistorschaltung zum Erzielen einer Spannungsbegrenzung, insbesondere eine Darlingtonschaltung mit einer Z-Diodeneinrichtung.

Die einfachste Schaltung zum Erzielen von Spannungsbegrenzung ist eine bloße Z-Diode. Es ist jedoch schwierig und damit teuer, Z-Dioden zum Begrenzen hoher Leistung bei hoher Spannung herzustellen. Liegen diese Anforderungen vor, wird daher in der Regel eine Darlingtonschaltung verwendet, bei der zwischen dem Kollektor und der Basis eines beliebigen der beiden Leistungstransistoren der Darlingtonschaltung eine in Sperrichtung gepolte Z-Diodeneinrichtung liegt. Eine entsprechende Schaltung ist z. B. in einem integrierten Bauelement enthalten, wie es von der Anmelderin seit über zehn Jahren unter der Bezeichnung BUX 30 AV vertrieben wird. Bei diesem Bauelement liegt eine integrierte Z-Diode zwischen kollektor und Basis des ersten Transistors einer Darlingtonschaltung. Zwischen der Basis und den Emitter eines jeden der beiden Leistungstransistoren liegt eine Basis-Emitter-Widelstandseinrichtung, die im wesentlichen dazu dient, den Betrieb der Transistoren zu stabilisieren, insbesondere zu verhindern, daß diese nicht bei hoher Temperatur durch Sperrströme aufgesteuert werden. Insgesamt handelt es sich also um eine Leistungstransistorschaltung zum Erzielen einer Betriebsspannung mit:

- zwei Leistungstransistoren, die als Darlingtonschaltung zusammengeschaltet sind;
- einer Basis-Emitter-Widerstandseinrichtung zwischen der Basis und dem Emitter eines jeden der beiden Leistungstransistoren; und
- einer Z-Diode mit vorgegebener Durchbruchsspannung, die so gewählt ist, daß sie im ganzen Temperaturbereich, für den die Schaltung vorgesehen ist, unter der Begrenzungsspannung bleibt, welche Diodeneinrichtung in Sperrichtung zwischen Kollektor und Basis des ersten Leistungstransistors liegt.

Die genannte Beschaltung mit der Z-Diode hat den Vorteil, daß durch die Z-Diode nicht mehr der gesamte zu schaltende Strom fließen muß, sondern nur der Basisstrom für den ersten Transistor. Dieses Prinzip funktioniert nicht nur mit zwei als Emitterfolger zu einer Darlingtonschaltung zusammengeschalteten Leistungstransistoren, sondern es funktioniert auch mit einem einzelnen Transistor oder mit noch mehr als zwei zusammengeschalteten Transistoren. Wenn mindestens zwei Leistungstransistoren als Emitterfolger zusammengeschaltet sind, ist es unerheblich, bei welchem der Transistoren die Z-Diode zwischen Kollektor und Basis liegt.

Allerdings besteht bei der genannten Schaltung der Nachteil, daß sich die Begrenzungsspannung im wesentlichen wie die Durchbruchsspannung (nur um die sehr kleine Basis-Emitter-Spannung unterschieden) in Abhängigkeit von Fertigungsstreuungen und Temperaturschwankungen ändert.

EP-B-0 179 099 betrifft eine Leistungstransistorschaltung zum Erzielen einer Begrenzungsschaltung, die ebenfalls als Darlingtonschaltung ausgebildet ist. Die Schaltung ist als integriertes Bauteil mit mehreren pn-Übergängen realisiert, die von einer Deckelektrode überdeckt werden. Das von dieser Deckelektrode ausgehende elektrostatische Feld beeinflußt die Durchbruchsspannung, die allerdings bei konstantem elektrostatischem Feld stark temperaturabhängig ist. Zum Beseitigen dieses Nachteils ist in der genannten Schrift ein temperaturabhängiger Spannungsteiler beschrieben, der das von der Deckelektrode ausgehende elektrostatische Feld so verändert, daß die Durchbruchsspannung im wesentlichen temperaturunabhängig wird.

Aus der WO-A 8204509 ist eine Darlington-Transistor-Schaltung mit einem Leistungstransistor und einem Treibertransistor bekannt, bei der an die Basis des Treibertransistors eine Reihenschaltung aus einem Widerstand und einer Zenerdiode angeschlossen ist. Ferner ist parallel zur Emitter-Basis-Strecke des Treibertransistors ein weiterer Widerstand angeordnet. Dadurch wird der Leistungstransistor angeschaltet sobald eine bestimmte Spannung an der Zenerdiode anliegt. Durch das Verhältnis der beiden Widerstandswerte kann die Temperaturabhängigkeit der Einschaltspannung eingestellt werden. Weiterhin ist es vorgesehen der Zenerdiode mittels eines Spannungsteilers die Kollektorspannung des Leistungstransistors zuzuführen und diese entsprechend zu begrenzen.

Aus Patent Abstract of Japan vol. 16, no. 67 (E-1168) und JP-A-3262152 ist es bekannt, den Wert von Widerständen durch Strahlungsinduzierte Abtragung von Material der Widerstandsschicht einzustellen.

Aus Patent Abstract of Japan, vol. 4, no. 59 (E-9) [541] und JP-A-5529113 ist es bekannt, bei einem Leistungstransistor zur Verhinderung eines Spannungsdurchbruchs im Inversbetrieb parallel zur Basis-Kollektor-Strecke die Emitter-Kollektor-Strecke eines weiteren mit offener Basis betriebenen Transistors anzuordnen.

Aus der FR 2 363 897 ist eine monolithisch integrierte Darlington-Transistor-Anordnung bekannt, bei der zur Spannungsbegrenzung eine Reihenschaltung aus mitintegrierten Zenerdioden und Serienwiderstand zwischen der Basis und dem Kollektor der Darlington-Anordnung und jeweils ein Widerstand zwischen Basis und Emitter der einzelnen Transistoren angeordnet sind. Zumindest der Widerstand, der die Basen der beiden Transistoren der Darlington Anordnung verbindet, wird von einem Teil einer dotierten Epitaxie-Schicht gebildet und weist somit einen positivem Temperatur-Koeffizienten auf.

Der Erfindung liegt die Aufgabe zugrunde, eine Leistungstransistorschaltung anzugeben, mit der eine im wesentlichen temperaturunabhängige Begrenzungsspannung erzielt werden kann.

Die erfindungsgemäße Leistungstransistorschaltung zum Erzielen einer Begrenzungsspannung weist folgendes auf:

- einen Leistungstransistor;
- eine Basis-Emitter-Widerstandseinrichtung zwischen der Basis und dem Emitter des Leistungstransistors mit einem positiven Temperatur-Koeffizienten,
- eine Z-Diodeneinrichtung mit vorgegebener Druchbruchspannung, die so gewählt ist, daß sie im ganzen Temperaturbereich, für den die Schaltung vorgesehen ist, unter der Begrenzungsspannung bleibt, welche Diodeneinrichtung in Sperrrichtung zwischen Kollektor und Basis des Leistungstransistors liegt; und
- eine Kollektor-Basis-Widerstandseinrichtung, die mit der Diodeneinrichtung zwischen Kollektor und Basis des Leistungstransistors in Reihe liegt und einen negativen Temperaturkoeffizienten aufweist;
- wobei die Widerstandswerte von beiden Widerstandseinrichtungen so dimensioniert sind, daß die Kollektor-Emitter-Spannung bei durchgeschaltetem Leistungstransistor bei Zimmertemperatur um einige Prozent bis einige zehn Prozent über der Durchbruchspannung der Diodeneinrichtung liegt.

Typischerweise steigt die Durchbruchspannung der Diodeneinrichtung mit steigender Temperatur an. Dann muß bei der erfindungsgemäßen Schaltung der Widerstand der Kollektor-Basis-Widerstandseinrichtung ansteigen und derjenige der Basis-Emitter-Widerstandseinrichtung abnehmen, um dennoch die Begrenzungsspannung möglichst konstant zu halten.

Von besonderem Vorteil ist es, mindestens eine der beiden Widerstandseinrichtungen so auszubilden, daß ihr Widerstandswert einstellbar ist. Dann muß nämlich beim Herstellen der Z-Diodeneinrichtung nicht darauf geachtet werden, daß deren Durchbruchsspannung durch möglichst enge Fertigungstoleranzen möglichst wenig streut. Vielmehr kann nach dem Herstellen der Schaltung ein Abgleich mit Hilfe der Widerstandeinrichtungen erfolgen. Hierzu stehen bekannte Aufbauten zur Verfügung, z.B. ein Dünnschicht-Widerstand, dessen Widerstandswert durch laserinduzierte Abtragung einstellbar ist oder eine Parallelschaltung mehrerer Serienschaltungen aus jeweils einem Planarwiderstand und einer durchbrennbaren Diode. Unter "Planarwiderstand" ist hierbei sowohl ein Dünnschicht-Widerstand wie auch ein integrierter Widerstand zu verstehen, der z. B. eine Emitterstrecke (für relativ niedrige Widerstände) oder eine Basisstrecke (für niedrige bis hohe Widerstände) nutzt.

Von Vorteil ist es weiterhin, für die Z-Diodeneinrichtung einen Transistoraufbau mit offener Basis zu verwenden. Dann kann die Herstellung dieser Diodeneinrichtung nämlich in gleicher Weise wie die Herstellung der Leistungstransistoren erfolgen, wobei lediglich die Höhe und/oder der Verlauf der Dotierung geändert werden muß, um die Durchbruchsspannung gegenüber der der Leistungstransistoren zu erniedrigen.

Da die erfindungsgemäße Schaltung zum Schalten hoher Leistungen dient, ist es von Vorteil, in für sich bekannter Weise eine Darlingtonschaltung zu verwenden, also den in erfindungsgemäßer Weise beschalteten Leistungstransistor mit einem weiteren Leistungstransistor zusammenzuschalten.

Die Erfindung wird im folgenden anhand von durch Figuren veranschaulichten Ausführungsbeispielen näher erläutert.

Fig. 1: Schaltungsdiagramm einer erfindungsgemäßen Leistungstransistorschaltung zum Erzielen einer vorgegebenen Begrenzungsspannung mit Hilfe eines Spannungsteilers zwischen Kollektor und Emitter;

Fig. 2: Schaltungsdiagramm einer Darlingtonschaltung, in der der erste Leistungstransistor wie der Transistor in Fig. 1 beschaltet ist;

Fig. 3: Schaltungsdiagramm ähnlich dem der Darlingtonschaltung gemäß Fig. 2, wobei jedoch der zweite Leistungstransistor wie der Transistor von Fig. 1 beschaltet ist;

Fig. 4: Schaltungsdiagramm einer Widerstandseinrichtung mit einstellbarem Widerstandswert;

Fig. 5: schematischer Teilschnitt durch eine integrierte Halbleiterschaltung mit zwei Leistungstransistoren und einer Z-Diodeneinrichtung in Form eines Transistors mit offener Basis;

Fig. 6: Diagramm, in dem die Basis-Emitter-Sapnnung UBEE über der Kollektor-Emitter-Spannung aufgetragen ist;

Fig. 7A bis C: Schaltungsdiagramme entsprechend demjenigen von Fig. 4, jedoch mit drei Fällen konkreter Widerstandswerte zum Einstellen dreier unterschiedlicher Verläufe im Diagramm von Fig. 6; und

Fig. 8: Diagramm entsprechend dem von Fig. 6, wobei jedoch unterschiedliche Spannungsverläufe in Abhängigkeit von der Betriebstemperatur statt von Fertigungsstreuungen eingezeichnet sind.

In der folgenden Figurenbeschreibung ist häufig von Widerständen als Bauteilen und von deren Widerstandswert die Rede. Dabei wird für die Widerstandsbauteile und deren Widerstandswert jeweils dieselbe Bezeichnung verwendet, also z. B. RBEE für einen Widerstand, der zwischen Basis und Emitter eines Transistors liegt, wie auch für den Widerstandswert dieses Bauteils. Der Endbuchstabe "E" soll hier darauf hinweisen, daß es sich nicht um den internen Basis-Emitter-Widerstand des Transistors handelt, sondern um einen in einer externen Beschaltung zwischen Basis und Emitter liegenden Widerstand.

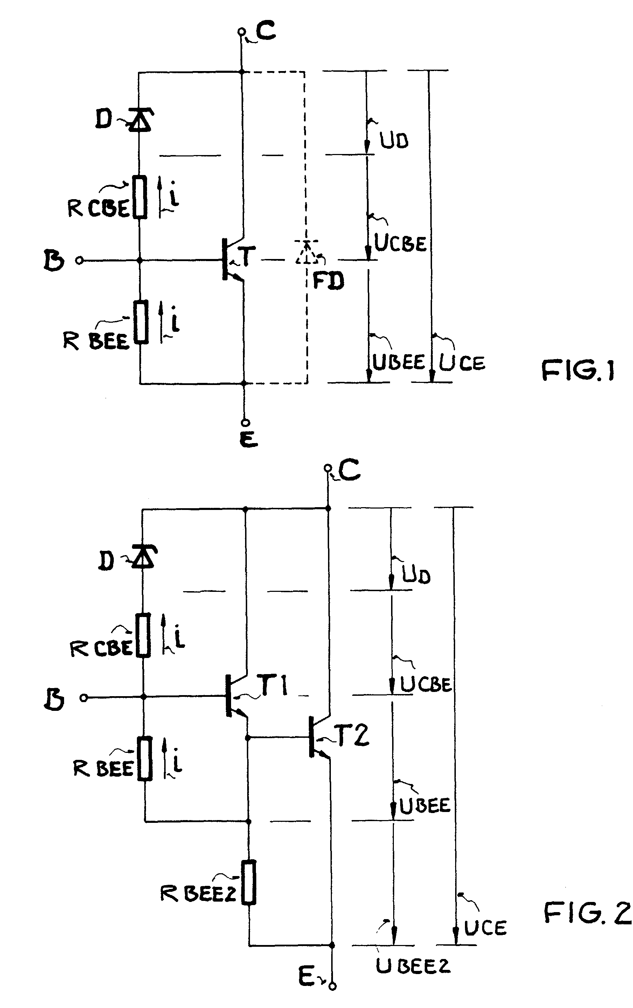

Der Transistor T gemäß Fig. 1 weist eine Basis-Emitter-Widerstandseinrichtung RBEE zwischen seiner Basis B und seinem Emitter E auf. Zwischen seinem Kollektor C und der Basis liegt eine Serienschaltung aus einer in Sperrrichtung gepolten Z-Diodeneinrichtung D und einer Kollektor-Basis-Widerstandseinrichtung RCBE.

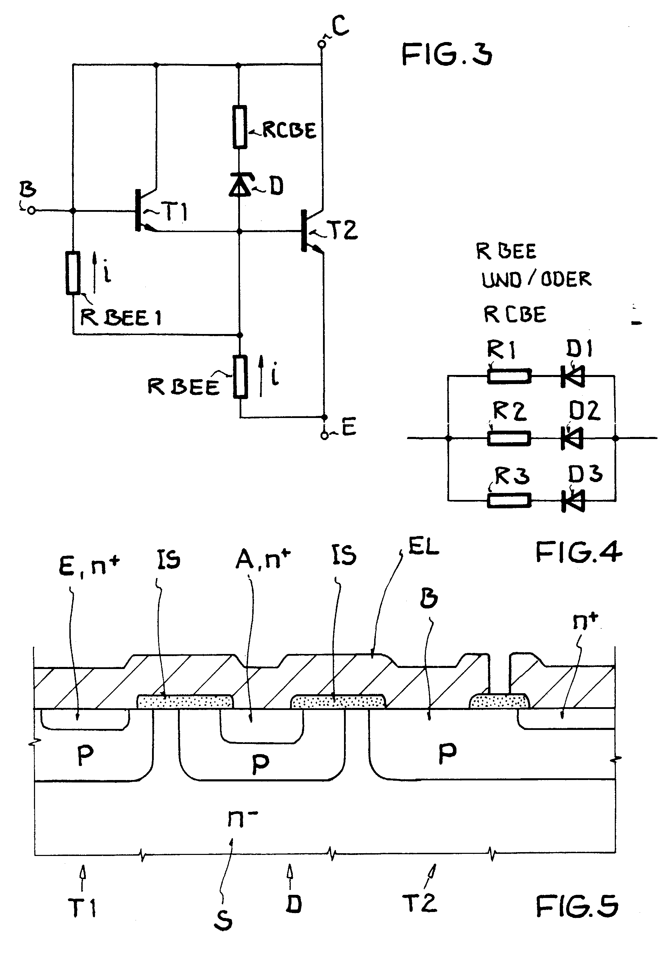

Die Fig. 2 und 3 zeigen ähnliche Schaltbilder für Darlingtonschaltungen. In beiden Fällen liegen ein erster Transistor T1 und ein zweiter Transistor T2 vor, wobei der erste Transistor T1 derjenige ist, dem die äußere Schaltspannung zuführbar ist. In Fig. 2 entspricht die Beschaltung des Transistors T1 völlig derjenigen des Transistors T in Fig. 1. Im Basis-Emitter-Kreis des zweiten Transistors T2 liegt eine zweite Basis-Emitter-Widerstandseinrichtung RBEE2. Im Fall von Fig. 3 ist der zweite Transistor T2 beschaltet wie der Transistor T in Fig. 1. Allerdings sind die Z-Diodeneinrichtung und die Kollektor-Basis-Widerstandseinrichtung RCBE in vertauschter Reihenfolge dargestellt. Im Basis-Emitter-Kreis des ersten Transistors T1 liegt in üblicher Weise eine externe Basis-Emitter-Widerstandseinrichtung RBEE1.

Die Temperaturkoeffizienten aller Widerstandseinrichtung sind insgesamt so gewählt, daß einer temperaturabhängigen Änderung der Durchbruchsspannung der Z-Diodeneinrichtung möglichst gut entgegengewirkt wird. Beim bevorzugten Ausführungsbeispiel ist darüber hinaus die Basis-Emitter-Widerstandseinrichtung RBEE als Einrichtung mit einstellbarem Widerstandswert ausgebildet. Jedoch können auch die Widerstandseinrichtungen RBEE1, RBEE2 und RBBE als solche mit einstellbarem Widerstandswert vorliegen.

In Fig. 1 ist noch gestrichelt eine Freilaufdiode FD eingezeichnet, die zweckmäßigerweise mitintegriert wird, wenn die Schaltung gemäß Fig. 1 als integriertes Bauteil ausgeführt wird. Entsprechendes gilt für die Schaltungen der Fig. 2 und 3. Die Freilaufdiode FD muß eine Durchschlagsspannung aufweisen, die höher ist als die Begrenzungsspannung der Schaltung. Da die Funktion dieser Diode für die Erfindung ohne Bedeutung ist, wird auf sie im weiteren nicht mehr eingegangen.

Gemäß Fig. 4 verfügt die Widerstandseinrichtung über eine Parallelschaltung von drei Serienschaltungen mit jeweils einem Widerstand und einer Diode, welche Bauteile die Bezugszeichen R1, D1; R2, D2 und R3, D3 tragen. Die Widerstandswerte aller drei Widerstände R1, R2 und R3 sind voneinander verschieden, so daß sich durch unterschiedliche Kombinationen durchgebrannter Dioden insgesamt acht unterschiedliche Widerstandswerte einstellen lassen. Der höchste Widerstandswert eines einzelnen der Widerstände entspricht zugleich dem höchstmöglichen Widerstandswert der Widerstandseinrichtung, während der geringste Widerstandswert bei intakter Parallelschaltung aller drei Widerstände erzielt wird.

Ein variabler Widerstandswert läßt sich jedoch nicht nur durch das Durchbrennen von Dioden in einer Parallelschaltung von Widerständen erzielen, sondern auch z. B. dadurch, daß Bereiche eines Dünnschicht-Widerstands z. B. mit einem Laser- oder Ionenstrahl abgetragen oder abgetrennt werden. Der Dünnschicht-Widerstand wird so hergestellt, daß er einen Widerstandswert aufweist, der dem niedrigsten gewünschten Widerstandswert entspricht. Durch Entfernen von Material wird dann der Widerstand bis auf den gewünschten Wert erhöht.

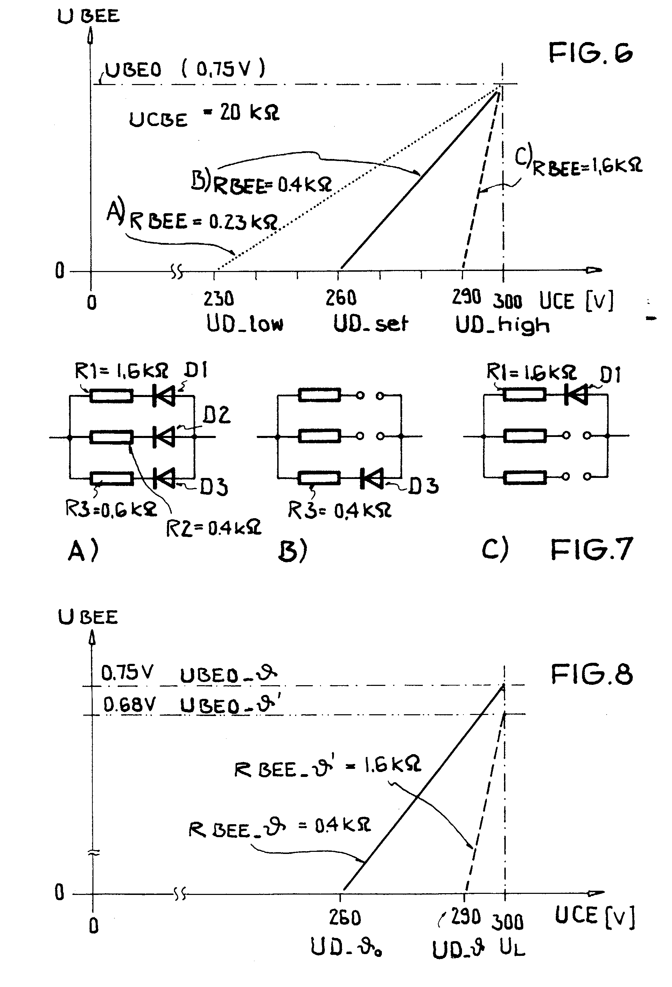

Fig. 5 veranschaulicht, wie sich die Z-Diodeneinrichtung in der Schaltung von Fig. 3 einfach realisieren läßt. Sie ist nämlich als Transistor mit offener Basis in einem Halbleitersubstrat S ausgebildet. Dies hat den Vorteil, daß die Herstellabläufe für die Z-Diodeneinrichtung D dieselben sind wie für die Leistungstransistoren T1 und T2, nur mit einer Variation in bezug auf die Tiefe und/oder Dotierung der Emitterschicht oder die Dotierung des Basisschicht, um die Durchbruchsspannung der Diode gegenüber der der Leistungstransistoren zuerniedrigen. In Fig. 5 sind der Emitteranschluß E des Transistors T1, der Anodenanschluß A der Z-Diodeneinrichtung D und der Basisanschluß B des Transistors T2 mit den eben genannten Buchstaben ebenso gekennzeichnet wie in Fig. 3. Diese Anschlüsse werden von einer gemeinsamen Elektrode EL kontaktiert, unter der teilweise eine Isolierschicht IS liegt.

In Fig. 1 sind rechts neben dem Schaltungsdiagramm die Spannungsverhältnisse dargestellt, wie sie für den Fall gelten, daß die Kollektor-Emitter-Spannung UCE bereits die Durchbruchsspannung UD der Z-Diodeneinrichtung E überschritten hat. Für die Spannung UCE gilt dann:

$$UCE = UD + i \cdot (RCBE + RBEE).$$

Umgeformt in den Strom i, wie er u. a. durch den Widerstand RBEE fließt, gilt dann:

$$i = (UCE - UD)/(RCBE + RBEE). \qquad (1)$$

Für die an der Basis B des Transistors T anliegende Spannung UBEE gilt dann:

$$UBEE = RBEE \cdot i \qquad (2)$$

Aus den Gleichungen (1) und (2) folgt:

$$UBEE = (UCE - UD) \cdot [RBEE/(RCBE + RBEE)] \text{ oder}$$

$$UBEE = k1 \cdot UCE - k2 \qquad (3),$$

mit

$$k1 = RBEE/(RCBE + RBEE$$

und

$$k2 = k1 \cdot UD.$$

Aus Gleichung (3) ist erkennbar, daß die an der Basis anliegende Spannung UBEE linear mit der Spannung UCE anwächst. Schließlich wird eine Basis-Emitter-Spannung erreicht, bei der ein Basisstrom fließt, der zum Durchschalten des Transistors T führt. Es handelt sich um die Basis-Emitter-Spannung UBE0 des Transistors in Durchlaßrichtung. Sobald der Transistor durchgeschaltet hat, steigt die Spannung UCE kaum mehr weiter an, sondern sie hält im wesentlichen eine Begrenzungsspannung UL.

Der eben geschilderte Spannungsverlauf für die Spannung UBEE ist in Fig. 6 für drei unterschiedliche Fälle dargestellt. Als Begrenzungsspannung UL ist ein Wert von 300 V angenommen. Die Z-Diodeneinrichtung D sei für eine Soll-Durchbruchsspannung UD set von 260 V ausgelegt, jedoch seien Fertigungsschwankungen von etwas mehr als ± 10 % zulässig, nämlich von einem unteren Wert UD_low von 230 V bis zu einem oberen Wert UD_high von 290 V. Der Widerstand RCBE sei zu 20 kΩ festgelegt. Die Spannung UBE0 sei 0,75 U. Der einzige freie Parameter, der dann noch ein Kompensieren der unterschiedlichen Durchbruchsspannungen erlaubt, ist der Wert des Widerstandes RBEE. Für diesen folgt aus Gleichung (3) unter der Annahme, daß die Spannung UCE den Wert UL einnimmt, wenn die Spannung UBEE den Wert UBE0 erreicht:

$$RBEE = RCBE \cdot UBE0/(UL - UD - UBE0) \qquad (4)$$

Setzt man in diese Gleichung die oben angegebenen Werte ein, ergibt sich für einen Fall A, in dem die Spannung UD den Wert von 230 V hat, ein Widerstandswert RBEE von 0,23 kΩ; dieser Fall ist im Diagramm von Fig. 6 punktiert eingezeichnet. Für den Sollfall von 260 V ergibt sich in einem Fall B ein Widerstandswert RBEE von 0,4 kΩ; der zugehörige Spannungsverlauf für UBEE ist durchgezogen dargestellt. Für den oberen Grenzwert der Durchbruchsspannung von 290 V ergibt sich schließlich in einem Fall C ein Widerstandswert RBEE von 1,6 kΩ; dieser Fall ist gestrichelt eingezeichnet.

Die Schaltungsdiagramme der Fig. 7A bis C konkretisieren die allgemeine Schaltung von Fig. 4 für die drei eben genannten Fälle A bis C. Der Widerstand R1 von Fig. 4 hat in Fig. 7 den Wert 1,6 kΩ, der Widerstand R2 den Wert 0,6 kΩ und der Widerstand R3 den Wert 0,4 kΩ. Dies ergibt in Parallelschaltung in etwa die geforderten 0,23 kΩ für den Wert des Widerstandes RBEE im Fall A. Gemäß Fig. 7B sind die Dioden D1 und D2 durchgebrannt, weswegen nur noch der dritte Widerstand von 0,4 Ω vorhanden ist, der genau dem Wert des Widerstandes RBEE des Sollfalls B entspricht. Gemäß Fig. 7C schließlich sind die Dioden D2 und D3 durchgebrannt, weswegen nur noch der Widerstand R1 von 1,6 kΩ vorhanden ist, also die Bedingung für Fall C erfüllt ist.

Im Fall A bricht die Z-Diodeneinrichtung bereits bei 230 V durch, während der Transistor erst bei 300 V durchschaltet. Wird ein Spannungspuls an die Schaltung gelegt, muß die Z-Diodenanordnung demgemäß in der Zeitspannung des Spannungsanstiegs zwischen der Durchbruchsspannung und der Begrenzungsspannung einem erheblichen Strom standhalten. Da die genannte Zeitspanne in der Regel schnell durchlaufen wird, übersteht die Z-Diodeneinrichtung dies unbeschadet, wenn sie entsprechend dimensioniert ist, was ohne größere Schwierigkeiten möglich ist.

Beim Erläutern der Fig. 6 und 7 wurde angenommen, daß der Widerstandswert des Widerstandes RBEE verändert wird, um die Begrenzungsspannung UL trotz fertigungsbedingt schwankender Durchbruchsspannung UD konstant zu halten. Aus Gleichung (3) ist jedoch ohne weiteres ersichtlich, daß sich die Spannungsverläufe von Fig. 6 auch erzielen lassen, wenn der Widerstandswert des Widerstandes RCBE verändert wird, und nach einfacher Umformung von Gleichung (4) läßt sich der jeweils erforderliche Widerstandswert konkret errechnen. In Fällen, in denen der Widerstandswert des Widerstandes RBEE erhöht werden muß, muß derjenige des Widerstandes RDBE erniedrigt werden, und umgekehrt. Es ist auch möglich, die Widerstandswerte beider Widerstände zu verändern.

Anhand der Fig. 4, 6 und 7 wurde zum Erleichtern des Verständnisses eine bevorzugte Ausführungsform der Erfindung beschrieben, die jedoch nicht unbedingt realisiert sein muß, nämlich die Ausführung mit einstellbaren Widerstandswerten zum Kompensieren von Fertigungsstreuungen in der Durchbruchsspannung UD. Wird die Z-Diodeneinrichtung jedoch schon mit der zulässigen Toleranz für die Durchbruchsspannung hergestellt, sind diese Abgleichsmaßnahmen gar nicht erforderlich. Aber auch dann weist die Schaltung von Fig. 1 eine bemerkenswerte Eigenschaft auf, nämlich diejenige einer sehr einfachen Kompensiermöglichkeit der Temperaturdrift der Durchbruchsspannung. Dies sei anhand von Fig. 8 erläutert.

Fig. 8 zeigt zwei Spannungsverläufe entsprechend denen von Fig. 6, und zwar zunächst den Verlauf, gemäß dem die Spannung UBEE ab einer Durchbruchsspannung von 260 V ansteigt. Diese Durchbruchsspannung ist in Fig. 8 nicht als UD_set bezeichnet, sondern als $UD\_\vartheta 0$, was anzeigen soll, daß es sich um die Durchbruchsspannung bei Zimmertemperatur handelt. Der zum Erreichen der Begrenzungsspannung UL für 300 V erforderliche Widerstandswert eines externen Basis-Emitter-Widerstandes RBEE ist mit $RBEE\_\vartheta$ bezeichnet. Da die Verhältnisse genau gleich liegen wie im Fall B von Fig. 6, ist der Widerstandswert 0,4 k$\Omega$.

Nun sei angenommen, daß sich die Durchbruchsspannung bei Erhöhung der Temperatur auf einen Wert $\vartheta'$ von 200 °C um etwas mehr als 10 % erhöhe, nämlich auf 290 V. Diese Spannung, die in Fig. 6 als UD_high bezeichnet ist, trägt in Fig. 8 die Bezeichnung $UD\_\vartheta'$. Damit wieder eine Begrenzungsspannung UL von 300 V erreicht wird, ist jedoch nicht mehr der Widerstandswert 1,6 k$\Omega$ des Widerstandes RBEE erforderlich, wie im Fall C von Fig. 6, sondern nur ein Wert von etwa 1,3 k$\Omega$, da die Basis-Emitter-Spannung UBE0 in Durchlaßrichtung um etwa 10 % abgenommen hat, also auf einen Wert $UBE0\_\vartheta'$ von etwa 0,65 bis 0,7 V.

Der Wert des Widerstandes RBEE mußte beim beschriebenen Beispiel von 0,4 k$\Omega$ bei Zimmertemperatur auf etwa 1,3 k$\Omega$ bei 200 °C zunehmen, um die Erhöhung der Durchbruchsspannung so zu kompensieren, daß die Begrenzungsspannung unverändert bei 300 V bleibt. Eine derartige Verdreifachung des Widerstandswertes bei einer Temperaturänderung um 200 °C ist z. B. bei Verwendung eines in Silizium implantierten Widerstandes möglich, wobei eine n- oder p-Dotierung von etwa $5 \times 10^{15}$ bis etwa $5 \times 10^{17}$ erforderlich ist. Ein ähnlicher Effekt könnte auch durch einen negativen Temperaturkoeffizienten für den Kollektor-Basis-Widerstand RCBE erzielt werden. Dies erfolgt zweckmäßigerweise mit einem Dünnschichtwiderstand.

Bereits weiter oben wurde ausgeführt, daß ein ziemlich großer Unterschied zwischen der Durchbruchsspannung und der Begrenzungsspannung besteht und baß die Z-Diodeneinrichtung so ausgebildet sein muß, daß sie in der Zeitspanne, in der die angelegte Spannung Von der Durchbruchsspannung auf die Begrenzungsspannung ansteigt, einen hohen Strom leiten muß, ohne daß die Gefahr einer Beschädigung besteht. Diese Gefahr ist dann etwas verringert, wenn die Soll-Durchbruchsspannung bei Zimmertemperatur UD_set bzw. $UD\_\vartheta 0$ etwas näher an die Begrenzungsspannung herangerückt wird. Dann rückt aber auch die höchstmögliche Durchbruchsspannungs, wie sie aufgrund von Fertigungsstreuungen und/oder aufgrund von Temperaturerhöhung möglich ist, näher an die Begrenzungsspannung heran. Je näher dieses Heranrücken ist, desto größer wird das Verhältnis der Widerstandswerte des Widerstands RBEE, wie sie in Fällen auftreten, die den Fällen C und B von Fig. 6 entsprechen. Es muß dann unter Umständen ein relativ großer positiver Temperaturkoeffizient für den Widerstand RBEE und ein relativ großer negativer Temperaturkoeffizient für den Widerstand RCDE gewählt werden, um die Begrenzungsspannung UL konstant halten zu können. Ziemlich einfach lassen sich die erforderlichen Widerstandsänderungen realisieren, wenn die Durchbruchsspannung, die maximal auftreten kann, mindestens 2 % unter der Begrenzungsspannung liegt und die Durchbruchsspannung nur um etwa ± 5 % schwankt. Der für die Fig. 6 und 8 vorausgesetzte Fall, wo die höchste Durchbruchsspannung etwa 3 % unter der Begrenzungsspannung liegt und die Variationsbreite der Durchbruchsspannung etwa ± 12 % beträgt, ist ebenfalls leicht realisierbar, wie dies das Beispiel von Fig. 7 und die angegebenen erforderlichen Temperaturkoeffizienten zeigen.

In den Fällen der Darlingtonschaltungen der Fig. 2 und 3 ist in Gleichung (1) und damit auch den Gleichungen (3) und (4) noch die am Widerstand RBEE2 bzw. RBEE1 abfallende Spannung zu berücksichtigen, z. B. die Spannung UBE2, wie sie in der Spannungsdarstellung in Fig. 2 rechts eingezeichnet ist. Da diese Spannung jedoch mit maximal 0,8 V (UBE0 bei Zimmertemperatur) anzusetzen ist, kann sie in allen Gleichungen gegenüber der viel größeren Durchbruchsspannung UD vernachlässigt werden. Für die Schaltungen gemäß den Fig. 2 und 3 gilt damit alles entsprechend, was vorstehend anhand von Fig. 1 erklärt und als Dimensionierung beschrieben wurde.

**Patentansprüche**

1. Leistungstransistorschaltung zum Erzielen einer Begrenzungsspannung (UL), mit:

   - einem Leistungstransistor (T; T1; T2);
   - einer Basis-Emitter-Widerstandseinrichtung (RBEE) zwischen der Basis und dem Emitter des Leistungstransistors, die einen positiven Temperaturkoeffizienten aufweist;
   - einer Z-Diodeneinrichtung (D) mit vorgegebener Durchbruchspannung, die so gewählt ist, daß sie im ganzen Temperaturbereich, für den die Schaltung vorgesehen ist, unter der Begrenzungsspannung bleibt, welche Diodeneinrichtung in Sperrrichtung zwischen Kollektor und Basis des Leistungstransistors liegt;
   - einer Kollektor-Basis-Widerstandseinrichtung (RCBE), die mit der Z-Diodeneinrichtung zwischen Kollektor und Basis des Leistungstransistors in Reihe liegt;

   dadurch gekennzeichnet,
   daß die Kollektor-Basis-Widerstandseinrichtung (RCBE) einen negativen Temperaturkoeffizienten aufweist und die Widerstandswerte der beiden Widerstandseinrichtungen so dimensioniert sind, daß die Kollektor-Emitter-spannung bei durchgeschaltetem Leistungstransistor bei Zimmertemperatur um einige Prozent bis einige zehn Prozent über der Durchbruchsspannung der Z-Diodeneinrichtung liegt.

2. Schaltung nach Anspruch 1, dadurch gekennzeichnet, daß mindestens eine der beiden Widerstandseinrichtungen (RCBE, RBEE) so ausgebildet ist, daß ihr Widerstandswert einstellbar ist.

3. Schaltung nach einem der Ansprüche 1 oder 2, dadurch gekennzeichnet, daß mindestens eine der beiden Widerstandseinrichtungen als Dünnschichtwiderstand auf dem den Leistungstransistor enthaltenden Halbleiter-Substrat ausgebildet ist, wobei der Widerstandswert des Dünnschicht-Widerstands durch strahlinduzierte Abtragung einstellbar ist.

4. Schaltung nach Anspruch 1, dadurch gekennzeichnet, daß mindestens eine der beiden Widerstandseinrichtungen (RCBE, RBEE) als Parallelschaltung mehrerer Serienschaltungen aus jeweils einem Planarwiderstand (R1, R2, R3) und einer durchbrennnbaren Diode (D1, D2, D3) ausgebildet ist.

5. Schaltung nach einem der Ansprüche 1 bis 4, dadurch gekennzeichnet, daß die Z-Diodeneinrichtung (D) einen Transistoraufbau mit offener Basis aufweist (Fig. 5).

6. Schaltung nach einem der Ansprüche 1 bis 6, dadurch gekennzeichnet, daß der Leistungstransistor (T1; T2), zwischen dessen Kollektor und Emitter die Z-Diodeneinrichtung (D) liegt, mit einem weiteren Leistungstransistor (T2 bzw. T1) ohne eine solche Diodeneinrichtung zu einer Darlingtonschaltung zusammengeschaltet ist.

**Claims**

1. A power transistor circuit for obtaining a limiting voltage (UL) comprising:

   - a power transistor (T; T1; T2);
   - a base-emitter resistance device (RBEE) between the base and the emitter of the power transistor, which resistance device (RBEE) has a positive temperature coefficient;
   - a Zener diode device (D) with a predetermined breakdown voltage selected such that it remains below the limiting voltage in the whole of the temperature range for which the circuit is provided, which diode device is arranged in the blocking direction between the collector and the base of the power transistor;
   - a collector-base resistance device (RCBE) which is arranged in series with the Zener diode device between the collector and the base of the power transistor;

   characterised in that the collector-base resistance device (RCBE) has a negative temperature coefficient and the resistance values of the two resistance devices are dimensioned such that at room temperature when the power transistor is switched on the collector-emitter voltage exceeds the breakdown voltage of the Zener diode device by a few percent to a few tens of percent.

2. A circuit according to Claim 1, characterised in that at least one of the two resistance devices (RCBE, RBEE) is designed such that its resistance value is adjustable.

3. A circuit according to one of Claims 1 or 2, characterised in that at least one of the two resistance devices is formed by a thin-film resistor on the semiconductor substrate containing the power transistor, where the resistance value of the thin-film resistor is adjustable by means of beam-induced removal.

4. Circuit according to Claim 1, characterised in that at least one of the two resistance devices (RCBE, RBEE) is formed by a parallel arrangement of a plurality of series circuits each comprising a planar resistor (R1, R2, R3) and a diode (D1, D2, D3) which can be burned out.

5. A circuit according to one of Claims 1 to 4, characterised in that the Zener diode device (D) has a transistor construction with an open base (Fig. 5).

6. A circuit according to one of Claims 1 to 6, characterised in that the power transistor (T1; T2), between whose collector and emitter the Zener diode device (D) is arranged, is connected to a further power transistor (T2; T1), which does not possess such a diode device, to form a Darlington circuit.


**Revendications**

1. Circuit à transistor de puissance en vue de l'obtention d'une tension de limitation (UL), comportant :

   - un transistor de puissance (T; T1; T2);
   - une résistance base-émetteur (RBEE) entre la base et l'émetteur de puissance, qui présente un coefficient de température positif;
   - une diode Z (D) à tension de claquage prédéterminée, qui est choisie de sorte qu'elle demeure dans toute la plage de température, pour laquelle est prévu le circuit, au-dessous de la tension de limitation, diode se trouvant dans le sens non passant entre collecteur et base du transistor de puissance;
   - une résistance collecteur-base (RCBE), qui se trouve en série avec la diode Z entre collecteur et base du transistor de puissance;

      caractérisé en ce que
      la résistance collecteur-base (RCBE) présente un coefficient de température négatif et les valeurs ohmiques des deux résistances sont dimensionnées de sorte que la tension collecteur-émetteur lors de la conduction du transistor de puissance à température ambiante se trouve entre quelques pourcents et quelques dizaines de pourcents au-dessus de la tension de claquage de la diode Z.

2. Circuit selon la revendication 1, caractérisé en qu'au moins une des deux résistances (RCBE, RBEE) est choisie de sorte que sa valeur ohmique soit réglable.

3. Circuit selon l'une des revendications 1 ou 2, caractérisé en ce qu'au moins une des deux résistances est réalisée sous la forme d'une résistance à couche mince sur le substrat semiconducteur contenant le transistor de puissance, la valeur ohmique de la résistance à couche mince étant réglée par enlèvement de matière provoqué par rayonnement.

4. Circuit selon la revendication 1, caractérisé en ce qu'au moins une des deux résistances (RCBE, RBEE) est réalisée par montage en parallèle de plusieurs circuits séries se composant respectivement d'une résistance planaire (R1, R2, R3) et d'une diode pouvant claquer (D1, D2, D3).

5. Circuit selon l'une quelconque des revendications 1 à 4, caractérisé en ce que la diode Z (D) présente une structure de transistor à base ouverte (Figure 5).

6. Circuit selon l'une quelconque des revendications 1 à 6, caractérisé en ce que le transistor de puissance (T1; T2) entre le collecteur et l'émetteur duquel se trouve la diode Z (D), est connecté en un montage Darlington avec un autre transistor de puissance (T2 respectivement T1) ne comportant pas une telle diode.

EP 0 560 185 B1

FIG.1

FIG.2

FIG.3

B

T1

RCBE

D

T2

C

RBEE1

i

RBEE

i

E

R BEE
UND / ODER
R CBE

R1    D1

R2    D2

R3    D3

FIG.4

E, n+    IS    A, n+    IS    EL    B    n+

P    P    P

n−

T1    S    D    T2    FIG.5

EP 0 560 185 B1

FIG.6

FIG.7

FIG.8

11